# EUROPEAN PATENT APPLICATION

(11) **EP 4 550 436 A2**
(43) Date of publication of application: **07.05.2025**
(21) Application number: 25164127.0
(22) Date of filing: 17.03.2025
(51) Int. Cl.: H01M 4/04, H01M 10/0525, H01M 10/058, H01M 10/44, H01M 10/48

(54) **CONTROL METHOD FOR LITHIUM-ION BATTERY FORMATION AND LITHIUM-ION BATTERY FORMATION SYSTEM**

(30) Priority: 31.10.2024 CN 202411548356
(71) Applicant: Zhejiang Jinko Energy Storage Co., Ltd., Jiaxing, Zhejiang 314415 (CN)
(72) Inventor: SHI, Yutao, Haining, 314415 (CN); MA, Yujun, Haining, 314415 (CN); YANG, Zixiang, Haining, 314415 (CN)
(74) Representative: Haseltine Lake Kempner LLP

(57) **Abstract**

Disclosed are a control method for lithium-ion battery formation and a lithium-ion battery formation system. The control method includes: determining film formation quality of a target lithium-ion battery; obtaining a plurality of formation data sets of the lithium-ion battery, each of which includes a plurality of data groups in a one-to-one correspondence with a plurality of formation time points during the formation process; determining an optimal film formation quality corresponding to each formation time point from the plurality of the formation data sets according to constraint conditions, and obtaining an expected film formation quality corresponding to each formation time point; and adjusting target parameters in a parameter adjustment order determined according to a deviation when the deviation between the film formation quality and the expected film formation quality does not satisfy a predetermined requirement.

## Description

### TECHNICAL FIELD

The present application relates to the field of lithium-ion battery formation, and in particular to a control method for lithium-ion battery formation and a lithium-ion battery formation system.

### BACKGROUND

A lithium-ion battery formation process is configured to activate a battery cell during an initial charging thereof and form a solid electrolyte interface (SEI) film at a negative electrode of the battery cell. The quality of the SEI film directly determines a short-term electrical performance and a long-term cycle/storage performance of the battery cell, and is a prerequisite for the stability of the electrical performance of the battery cell.

In existing formation processes, constant charging currents are usually adopted at two to three stages, and a negative pressure is continuously drawn during the film formation process, to draw away gas produced during the film formation process. In the mass production process from feeding powder to forming battery cells, there will inevitably be differences in material batches and accumulation of dimensional tolerances, thus resulting in performance differences between battery cells. The existing formation processes are obviously unable to be adapted to the differences between battery cells, which aggravates the difference in the SEI film formation between battery cells in the formation process, thereby aggravating the problem of inconsistency of electrical performance of the battery cells.

### SUMMARY

The main purpose of the present application is to provide a control method for lithium-ion battery formation and a lithium-ion battery formation system, to at least solve a problem of a great difference in SEI film formation during a formation process of the prior art.

In order to achieve the above-mentioned purpose, according to one aspect of the present application, a control method for lithium-ion battery formation is provided, and the control method includes: determining film formation quality of a target lithium-ion battery, where the target lithium-ion battery is a lithium-ion battery in a formation process; obtaining a plurality of formation data sets of the lithium-ion battery, where each formation data set includes a plurality of data groups in a one-to-one correspondence with a plurality of formation time points during the formation process, and each data group includes historical film formation quality, a solid electrolyte interface (SEI) film impedance and an interface charge transfer impedance of a corresponding formation time point; determining an optimal film formation quality corresponding to each formation time point from the plurality of the formation data sets according to constraint conditions, and obtaining an expected film formation quality corresponding to each formation time point; where the constraint conditions include: for each formation time point, the SEI film impedance corresponding to the historical film formation quality being less than a first threshold, and the interface charge transfer impedance corresponding to the historical film formation quality being less than a second threshold; and adjusting target parameters in a parameter adjustment order determined according to a deviation, when the deviation between the film formation quality and the expected film formation quality does not satisfy a predetermined requirement, so that after the target parameters are adjusted, the deviation corresponding to the formation process meets the predetermined requirement. The target parameters are to-be-adjusted formation process parameters determined according to the deviation, the parameter adjustment order is an adjustment order of the target parameters, and formation process parameters are process parameters affecting the film formation quality in the formation process.

Formation working conditions corresponding to any two of the formation data sets are different, and each data group in each formation data set further includes formation gas production data at a formation time point during a formation process corresponding to each data group; and the constraint conditions further include: a change rate of the formation gas production data corresponding to the historical film formation quality at each formation time point being less than a third threshold.

Determining the optimal film formation quality corresponding to each formation time point from the plurality of the formation data sets according to the constraint conditions includes: establishing a planning model, wherein a variable of the planning model is the historical film formation quality, and a target of the planning model is that a weighted sum of the change rate of the formation gas production data, the SEI film impedance and the interface charge transfer impedance at a same formation time point is the minimum; and inputting the plurality of formation data sets into the planning model, and determining the optimal formation quality corresponding to each formation time point according to the constraint conditions to obtain optimal film formation qualities corresponding to the plurality of formation time points respectively.

Before determining the film formation quality of the target lithium-ion battery, the method further includes determining that the formation process parameters include a formation current, a remaining power, and a formation temperature based on a film formation reaction equation of the formation process.

Adjusting the target parameters in the parameter adjustment order determined according to the deviation when the deviation between the film formation quality and the expected film formation quality does not satisfy the predetermined requirement includes: when the deviation is greater than a fourth threshold and less than or equal to a fifth threshold, determining that the target parameters include the formation current and the remaining power, and determining that the parameter adjustment order is to adjust the formation current and the remaining power in sequence; when the deviation is greater than the fifth threshold and less than or equal to the sixth threshold, determining that the target parameters include the formation temperature and the formation current, and determining that the parameter adjustment order is to adjust the formation current and the formation temperature in sequence; and when the deviation is greater than the sixth threshold, determining that the target parameters include the formation temperature, the remaining power and the formation current, and determining that the parameter adjustment order is to adjust the formation current, the remaining power and the formation temperature in sequence. The predetermined requirement is that the deviation between the film formation quality and the expected film formation quality is less than or equal to the fourth threshold. The fourth threshold is less than the fifth threshold, and the fifth threshold is less than the sixth threshold.

Determining the film formation quality of the target lithium-ion battery includes: obtaining actual parameter values of the formation process parameters of the target lithium-ion battery; establishing a film formation quality prediction model that characterizes a corresponding relationship between the formation process parameters and the film formation quality; and determining the film formation quality corresponding to the actual parameter values based on the film formation quality prediction model and the actual parameter values.

In an embodiment, the first threshold is in a range of 0.5Ω±5%, the second threshold is in a range of 2Ω±5%, and the third threshold is in a range of 16 mL/V±5%.

In an embodiment, after obtaining the expected film formation quality corresponding to each formation time point, and before adjusting the target parameters in the parameter adjustment order determined according to the deviation, the method further includes: determining a formation time point corresponding to the film formation quality as a target time point, and determining an expected film formation quality corresponding to the target time point as a target expected quality, wherein the target expected quality is the expected film formation quality corresponding to the film formation quality; and calculating a difference between the film formation quality and the target expected quality to obtain the deviation.

In an embodiment, establishing the film formation quality prediction model includes: obtaining a training data set, wherein the training data set includes a plurality of training data groups, each training data group includes historical parameter values of the formation process parameters, and the historical film formation quality of the lithium-ion battery obtained through information using the historical parameter values; establishing an initial prediction model; and adjusting model parameters of the initial prediction model according to the training data set to obtain the film formation quality prediction model.

In an embodiment, the prediction model includes one or a coupling of more of a machine learning model, a deep learning model, and a semi-empirical model.

In an embodiment, a weight value of the change rate of the formation gas production data, a weight value of the SEI film impedance, and a weight value of the interface charge transfer impedance are the same. In an embodiment, the formation working conditions include charging rates. In an embodiment, the formation working conditions comprise formation negative pressures. Further the formation negative pressures include -60 kPa, -70 kPa, and -80 kPa. In an embodiment, the formation working conditions comprise states of charge. Further, the states of charge comprise 6%, 15%, and 30%.

In a second aspect, the application provides a lithium-ion battery formation system, which includes a lithium-ion battery formation device and a control device for the lithium-ion battery formation device. The lithium-ion battery formation device is configured to perform a lithium-ion battery formation process. The control device includes one or more processors, a memory, and one or more programs. The one or more programs are stored in the memory and configured to be executed by the one or more processors. The one or more processors, when executing the one or more programs, implement any one of the above control methods.

In a third aspect, the application provides a computer-readable storage medium, having a program stored thereon. The program, when executed by a processor, executes any one of the control methods above.

In a fourth aspect, the application provides a computer device, including a processor and a memory. The memory has a computer program stored thereon, and the processor, when executing the computer program, implements any one of the above control methods.

In a fifth aspect, the application provides a computer program product, including computer instructions. The computer instructions, when executed by a processor, execute any one of the control methods above.

In the technical solution of the present application, the expected film formation quality at each formation time point during the formation process are determined from the plurality of formation data sets, and the target parameters affecting the film formation quality are adjusted in the parameter adjustment order according to the deviation between the actual film formation quality of the lithium-ion battery in the formation process and the expected film formation quality, so that after the adjustment, the deviation satisfies the predetermined requirement, that is, the adjusted SEI film formation quality approximates to the expected film formation quality, thereby realizing an online regulation of the SEI film formation quality during the formation process of the lithium-ion battery, ensuring the great consistency of the SEI film formation quality of different battery cells, solving the problem of the great difference in the SEI film formation during the formation process of the prior art, and ensuring the great consistency of the electrical performance of the battery cells.

### BRIEF DESCRIPTION OF THE DRAWINGS

The drawings constituting part of the present application are used to provide a further understanding of the present application. The exemplary embodiments and descriptions of the present application are used to explain the present application but not intended to constitute an improper limitation on the present application. In the drawings:
FIG. 1 shows a schematic flow chart of a control method for lithium-ion battery formation according to an embodiment of the present application;
FIG. 2 is a block diagram showing a control device for lithium-ion battery formation according to an embodiment of the present application.

### DETAILED DESCRIPTION OF THE EMBODIMENTS

It should be noted that, in the absence of conflict, the embodiments and features in the embodiments of the present application can be combined with each other. The present application will be described in detail hereinafter with reference to the accompanying drawings and in combination with the embodiments.

As described in the background, there is a great difference in SEI film formation between battery cells during a formation process of the prior art. In order to solve the above technical problem, the embodiments of the present application provide a method for control lithium-ion battery formation and a lithium-ion battery formation system.

The technical solutions of the embodiments of the present invention will be described clearly and completely hereinafter in conjunction with the accompanying drawings of the embodiments of the present invention.

In an embodiment, the present application provides a control method for lithium-ion battery formation, which is executable on a mobile terminal, a computer terminal or a similar computing device. It should be noted that steps shown in the flow chart of the accompanying drawings can be executed in a computer system such as a set of computer executable instructions, and that, although a logical order is shown in the flow chart, in some cases, the shown or described steps can be executed in another order different from that shown herein.

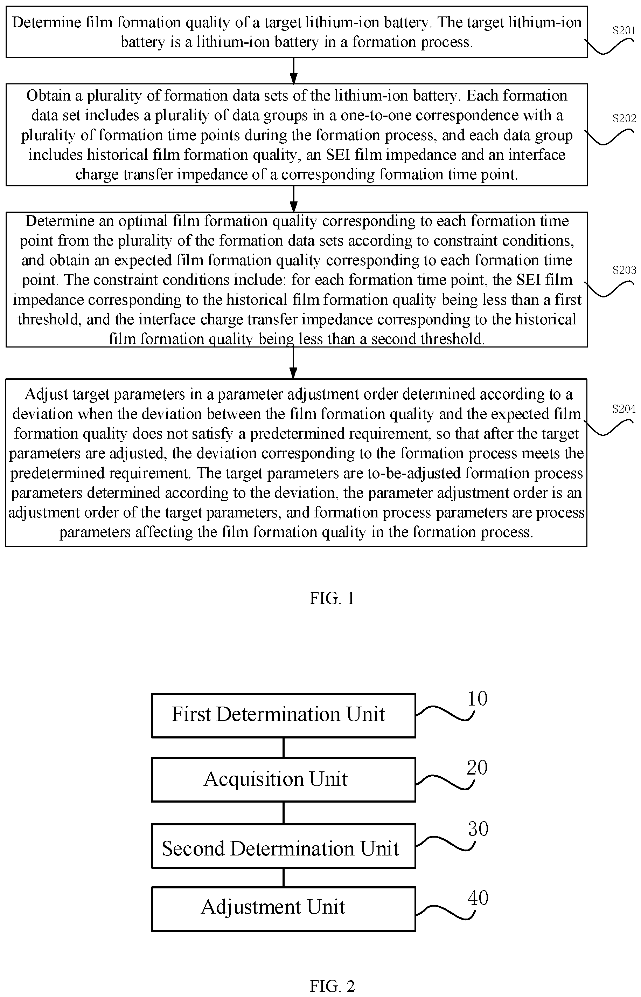

FIG. 1 shows a schematic flow chart of a control method for lithium-ion battery formation according to an embodiment of the present application, as shown in FIG. 1, the method includes the following steps S201 to S204.

In Step S201, film formation quality of a target lithium-ion battery is determined. The target lithium-ion battery is a lithium-ion battery in a formation process.

Specifically, the film formation quality refers to actual quality of the formed SEI film.

In Step S202, a plurality of formation data sets of the lithium-ion battery are obtained. Each formation data set includes a plurality of data groups, which are in a one-to-one correspondence with a plurality of formation time points during a formation process, and each data group includes historical film formation quality, an SEI film impedance and an interface charge transfer impedance of a corresponding formation time point.

Specifically, in each formation data set, each data group corresponding to a formation time point includes the historical film formation quality, the SEI film impedance and the interface charge transfer impedance. Different formation data sets include data groups correspond to the same formation time point. For example, the plurality of formation data sets each include data groups corresponding to the first formation time point, the second formation time point, etc., and the n-th formation time point, respectively. Therefore, the plurality of formation data sets each include a data group including the historical film formation quality, the SEI film impedance and the interface charge transfer impedance corresponding to each formation time point.

In Step S203, according to constraint conditions, an optimal film formation quality corresponding to each formation time point is determined from the plurality of the formation data sets, and an expected film formation quality corresponding to each formation time point is obtained. The constraint conditions include: for each formation time point, the SEI film impedance corresponding to the historical film formation quality being less than a first threshold, and the interface charge transfer impedance corresponding to the historical film formation quality being less than a second threshold.

Specifically, among the plurality of data groups corresponding to a formation time point, the historical film formation quality in a data group, in which the SEI film impedance is less than the first threshold and the interface charge transfer impedance is less than the second threshold, is the optimal film formation quality at this formation time point.

In Step S204, when a deviation between the film formation quality and the expected film formation quality does not satisfy a predetermined requirement, target parameters are adjusted in a parameter adjustment order determined according to the deviation, so that after the target parameters are adjusted, the deviation corresponding to the formation process meets the predetermined requirement. The target parameters are the to-be- adjusted formation process parameters determined according to the deviation, and the parameter adjustment order is an adjustment order of the target parameters, and formation process parameters are process parameters that affect the film formation quality in the formation process.

Specifically, when magnitudes of the deviations are different, and the corresponding to-be-adjusted formation process parameters are also different.

In the embodiments above, the film formation quality of the target lithium-ion battery in the formation process is first determined. Then, the plurality of formation data sets of the lithium-ion battery are obtained, and each formation data set includes the plurality of data groups, which are in a one-to-one correspondence with the plurality of formation time points during a formation process, and each data group includes the historical film formation quality, the SEI film impedance and the interface charge transfer impedance of a corresponding formation time point. Then, according to the constraint conditions, the optimal film formation quality corresponding to each formation time point is determined from the plurality of the formation data sets, and the expected film formation quality corresponding to each formation time point is obtained. The constraint conditions include: for each formation time point, the SEI film impedance corresponding to the historical film formation quality being less than the first threshold, and the interface charge transfer impedance corresponding to the historical film formation quality being less than the second threshold. Finally, when the deviation between the film formation quality of the target lithium-ion battery and the expected film formation quality does not satisfy the predetermined requirement, the target parameters that affect the film formation quality are adjusted in parameter adjustment order, so that after the adjustment, the deviation meets the predetermined requirement. In the present application, the expected film formation quality at each formation time point during the formation process are determined from the plurality of formation data sets, and the target parameters affecting the film formation quality are adjusted in the parameter adjustment order according to the deviation between the actual film formation quality of the lithium-ion battery in the formation process and the expected film formation quality, so that after the adjustment, the deviation satisfies the predetermined requirement, that is, the adjusted SEI film formation quality approximates to the expected film formation quality, thereby realizing an online regulation of the SEI film formation quality during the formation process of the lithium-ion battery, ensuring the great consistency of the SEI film formation quality of different battery cells, solving the problem of the great difference in the SEI film formation during the formation process of the prior art, and ensuring the great consistency of the electrical performance of the battery cells.

In an optional embodiment, the formation working conditions corresponding to any two of the formation data sets are different, and each data group in each formation data set further includes formation gas production data at a formation time point during a formation process corresponding to each data group, and the constraint conditions further include: a change rate of the formation gas production data corresponding to the historical film formation quality at each formation time point being less than a third threshold. In other words, the application determines expected film formation quality varying with formation time point under the optimal conditions based on the principles of a stable change of the formation gas production data, a relatively small SEI film impedance and a relatively small interface charge transfer impedance.

Specifically, different working conditions (such as different charging rates, different formation negative pressures, and different states of charge, etc.) are applied to the battery formation, and formation data sets under different formation working conditions are collected to obtain plurality of formation data sets. The different charging rates can be selected from 0.01C (characterizing that the battery is charged at a rate of 0.01 times its rated capacity per hour), 0.02C (characterizing that the battery is charged at a rate of 0.02 times its rated capacity per hour), and 0.1C (characterizing that the battery is charged at a rate of 0.1 times its rated capacity per hour), etc. The different formation negative pressures can be selected from -60 kPa, -70 kPa, and -80 kPa, etc. The different states of charge can be selected from 6%, 15%, and 30%, etc. The formation working conditions are not limited to the charging rates, the formation negative pressures, and the states of charge, and can also be other working conditions in the formation process. The specific values of the charging rate, formation negative pressure and state of charge are not limited to the data described above, and the formation working conditions and the specific values of different formation working conditions can be flexibly set by those skilled in the art according to actual conditions.

The formation gas production data may specifically be a formation gas production rate, which can be calculated based on obtained gas production amount in the formation process. The change rate of the formation gas production data is obtained by calculating a change rate of the gas production rate.

In addition, the SEI film impedance and the interface charge transfer impedance can be obtained by testing an electrochemical impedance spectroscopy (EIS) spectrum of the lithium-ion battery and identifying the EIS spectrum.

The specific values of the first threshold, the second threshold and the third threshold can set by those skilled in the art according to actual needs, so that a historical film formation quality in a data group can be selected from the plurality of data groups corresponding to each formation time point as the optimal film formation quality.

In an optional embodiment, the first threshold is in a range of 0.5*Ω* ± 5%, the second threshold is in a range of 2*Ω* ± 5%, and the third threshold is in a range of 16 *mL*/*V* ± 5%.

In order to further ensure that an optimal film formation quality corresponding to each formation time point can be determined relatively quickly, in some other optional embodiments of the present application, determining the optimal film formation quality corresponding to each formation time point from the plurality of the formation data sets according to the constraint conditions in step S203 includes: establishing a planning model, where a variable of the planning model is a historical film formation quality, and a target of the planning model is that a weighted sum of a change rate of the formation gas production data, SEI film impedance and an interface charge transfer impedance at the same formation time point is the minimum; inputting the plurality of formation data sets into the planning model, and determining the optimal formation quality corresponding to each formation time point according to the constraint conditions, to obtain the optimal film formation qualities corresponding to the plurality of formation time points respectively. In this embodiment, the planning model is established by taking the historical film formation quality as the variable, and by setting the target that the weighted sum of the change rate of the formation gas production data, the SEI film impedance and the interface charge transfer impedance is the minimum. The planning model is used to calculate the optimal solutions for the plurality of formation data sets, thereby quickly and efficiently obtaining the optimal film formation quality corresponding to each formation time point, which satisfies the conditions of the most stable change rate of the formation gas production data, the minimum SEI film impedance and the minimum interface charge transfer impedance.

For the target of the planning model, weight values of the change rate of the formation gas production data, SEI film impedance and the interface charge transfer impedance can be the same or different. The specific values of the weight values can be flexibly set by those skilled in the art as needed, and are not specifically limited herein.

In this embodiment, after obtaining the expected film formation quality corresponding to each formation time point in step S203, and before adjusting the target parameters in the parameter adjustment order determined according to the deviation in step 204, the method further includes: determining a formation time point corresponding to the film formation quality as a target time point, and determining the expected film formation quality corresponding to the target time point as a target expected quality, and the target expected quality being the expected film formation quality corresponding to the film formation quality; calculating a difference between the film formation quality and the target expected quality to obtain the deviation. Since there is an expected film formation quality at each formation time point in the formation process, in order to further ensure that the SEI film formation quality is controlled more accurately, in the present application, after determining the expected film formation quality corresponding to each of the plurality of formation time points, and before adjusting the target parameters in the formation process, the time point, when the film formation quality of the target lithium-ion battery is obtained, is determined as the target time point firstly, and the expected film formation quality corresponding to the target time point is the target expected quality, so that the target expected quality is determined as the expected film formation quality corresponding to the film formation quality, and then the difference between the film formation quality and the target expected quality is calculated to be used as the deviation, thereby ensuring that the deviation is relatively accurate, further ensuring that the SEI film formation quality regulated according to the deviation is relatively accurate, and further ensuring the great consistency of the adjusted SEI film formation quality of different battery cells.

According to some exemplary embodiments of the present application, before Step S201 of determining the film formation quality of the target lithium-ion battery, the method further includes determining that the formation process parameters include a formation current, a remaining power, and a formation temperature based on a film formation reaction equation of the formation process. In these embodiments, factors affecting the SEI film formation quality are identified based on the SEI film formation reaction equation of the formation process, to obtain the formation process parameters including the formation current, the remaining power and the formation temperature, thereby ensuring that the determined formation process parameters are relatively accurate, and facilitating a subsequent adjustment of the film formation quality made high efficiently and accurately based on these formation process parameters.

On this basis the embodiment above, in some embodiments, the step S204 of adjusting the target parameters in the parameter adjustment order determined according to the deviation when the deviation between the film formation quality and the expected film formation quality does not satisfy the predetermined requirement includes steps S2041 to S2043.

In Step S2041, when the deviation is greater than a fourth threshold and less than or equal to a fifth threshold, it is determined that the target parameters include the formation current and the remaining power, and it is determined that the parameter adjustment order is to adjust the formation current and the remaining power in sequence.

Specifically, when the deviation is greater than the fourth threshold and less than or equal to the fifth threshold, it indicates that the deviation is relatively small, and in this case, it is determined that the target parameters include the formation current and the remaining power, but exclude the formation temperature.

In Step S2042, when the deviation is greater than the fifth threshold and less than or equal to the sixth threshold, it is determined that the target parameters include the formation temperature and the formation current, and it is determined that the parameter adjustment order is to adjust the formation current and the formation temperature in sequence.

Specifically, when the deviation is greater than the fifth threshold and less than or equal to the sixth threshold, it indicates that the deviation is relatively large, and in this case, it is determined that the target parameters include the formation temperature and the formation current, but exclude the remaining power.

In Step S2043, when the deviation is greater than the sixth threshold, it is determined that the target parameters include the formation temperature, the remaining power and the formation current, and it is determined that the parameter adjustment order is to adjust the formation current, the remaining power and the formation temperature in sequence.

Specifically, when the deviation is greater than the sixth threshold, it indicates that the deviation is extremely large, and in this case, it is determined that the target parameters include the formation current, the remaining power, and the formation temperature.

In some embodiments above, the deviation between the film formation quality and the expected film formation quality satisfying the predetermined requirement means that the deviation is less than or equal to the fourth threshold. That is, the predetermined requirement is that the deviation between the film formation quality and the expected film formation quality is less than or equal to the fourth threshold. The fourth threshold is less than the fifth threshold, and the fifth threshold is less than the sixth threshold. The adjustment of the formation process is divided into three cases according to the deviation. A first case is that the deviation is greater than the fourth threshold and not greater than the fifth threshold. Compared with the predetermined requirement, the deviation of the film formation quality in the first case is not too large, and in the first case, it is determined that the target parameters include the formation current and the remaining power, and it is determined that the target parameters are adjusted in the order of adjusting the formation current and the remaining power in sequence. A second case is that the deviation is greater than the fifth threshold and not greater than the sixth threshold. Compared with the predetermined requirement, the deviation of the film formation quality in the second case is relatively large, and in the second case, it is determined that the target parameters include the formation current and the formation temperature, and it is determined that the target parameters are adjusted in the order of adjusting the formation current and the remaining power in sequence. The third case is that the deviation value is greater than the sixth threshold. Compared with the predetermined requirement, the film formation quality deviation in the third case is even larger, and in the third case, it is determined that the target parameters include the formation temperature, the remaining power and the formation current, and it is determined that the target parameters are adjusted in the order of adjusting the formation current, the remaining power and the formation temperature in sequence. The formation process is adjusted according to different cases, and the target parameters and the parameter adjustment order in a corresponding case are determined, so that the deviation can be efficiently and quickly adjusted to be not greater than the fourth threshold, thereby further ensuring that the film formation quality of the formation process is relatively stable and that the film formation effect is better, and further ensuring great consistency of the electrical performance of the battery cells.

Specifically, in each case, the plurality of target parameters in the formation process are adjusted in the parameter adjustment order, and after each target parameter is adjusted, it is determined whether the deviation meets the predetermined requirement, and by cyclically adjusting the plurality of target parameters, a closed-loop fine adjustment of the film formation quality is achieved.

In an embodiment, step S201 of determining the film formation quality of the target lithium-ion battery includes: obtaining actual parameter values of the formation process parameters of the target lithium-ion battery; establishing a film formation quality prediction model, which characterizes a corresponding relationship between the formation process parameters and the film formation quality; and determining the film formation quality corresponding to the actual parameter values based on the film formation quality prediction model and the actual parameter values. In this embodiment, by analyzing the actual parameter values of the formation process parameters through the film formation quality prediction model, a relatively accurate film formation quality corresponding to the actual parameter values can be obtained, so as to provide relatively accurate data support for the process parameters of the subsequent formation process.

The formation process parameters involved in the film formation quality prediction model include at least part of the formation current, the remaining power and the formation temperature.

The film formation quality prediction model may be any suitable prediction model. In an embodiment of the present application, establishing the film formation quality prediction model includes: obtaining a training data set, the training data set including a plurality of training data groups, each training data group including historical parameter values of the formation process parameters, and historical film formation quality of the lithium-ion battery obtained through information using the historical parameter values; establishing an initial prediction model; adjusting model parameters of the initial prediction model according to the training data set to obtain the film formation quality prediction model. In this embodiment, the film formation quality prediction model is obtained by establishing the prediction model and by training the prediction model by using the training data set. During the training process, the prediction model can automatically complete some repetitive tasks by learning patterns and rules in the data, thereby improving the efficiency and accuracy of a film formation quality prediction.

The prediction model includes one or a coupling of more of a machine learning model, a deep learning model, and a semi-empirical model, and specifically includes, but is not limited to, a linear regression model, a logistic regression model, a support vector machine (SVM) model, a decision tree model, and a random forest model, etc.

Optionally, before step S201 of determining the film formation quality of the target lithium-ion battery, the method further includes: according to a pseudo two-dimensional (P2D) theoretical model of the target lithium-ion battery, determining that the evaluation parameters of the film formation quality include at least one of: a battery DC internal resistance, a battery capacity, a peak value of battery voltage differential capacity, an integral value of the battery voltage differential capacity over voltage. That is, the film formation quality is characterized by at least one of the battery DC internal resistance, the battery capacity, the peak value of the battery voltage differential capacity, and the integral value of the battery voltage differential capacity over voltage. In the present application, based on the electrochemical reaction mechanism of the lithium-ion battery, the evaluation parameters characterizing the film formation quality are identified through the P2D model. The P2D model describes a charge distribution and a current distribution in the electrode by using a diffusion equation and a current equation, and the evaluation parameters that can more accurately characterize the film formation quality can be obtained.

Performance data comparisons between the lithium-ion battery obtained by the method of the present application and the lithium-ion battery obtained by the process in the prior art are shown in Table 1.

**Table 1**

| Performance Data | Process in the prior art | Method of the application |
|---|---|---|
| Capacity Tolerance Distribution During Grading | 4% | 1.5% |
| Battery Cell Shipment Voltage Tolerance | ±5 *mV* | ±3 *mV* |
| K-value Distribution | 3σ | 2.5σ |

It can be seen from Table 1 that, compared with the prior art, the method of the present application can ensure the stability and consistency of the film formation quality of different lithium-ion batteries, thereby improving the consistency of the electrical performance of the battery cells.

In order to enable those skilled in the art to understand the technical solutions of the present application more clearly, the implementation of the control method for lithium-ion battery formation of the present application will be described in detail hereinafter in conjunction with a specific embodiment.

An embodiment relates to a specific control method for lithium-ion battery formation, and the method includes the following steps S1 to S6.

In Step S1, set an initial formation current and a negative pressure, charge and form the battery cell, and measure a current and a voltage in real time.

In Step S2, based on the electrochemical reaction mechanism, the features, namely the evaluation parameters of the film formation quality, which affect the SEI film formation quality during the electrochemical reaction of the battery cell, are identified through the P2D model, to obtain the battery DC internal resistance, the battery capacity, the peak value of the battery voltage differential capacity, the integral value of the battery voltage differential capacity over voltage.

In Step S3, comprehensively consider the SEI film impedance, the interface charge transfer impedance and the formation gas production data, calibrate the expected film formation quality at each formation time point during the formation process offline, and determine an expected film formation quality curve under the optimal conditions based on the principle that the gas production rate curve is the most stable, and that the SEI film impedance and the interface charge transfer impedance are the minimum.

In Step S4, based on the SEI film formation reaction equation, extract the formation process parameters that affect the film formation quality, and obtain the formation current, the remaining power and the formation temperature.

In Step S5, establish a prediction model, train the prediction model according to the formation process parameters and the corresponding film formation quality to obtain the film formation quality prediction model. The model is trained by data collected during an initial trial running of a production line, and the model is optimized by data continuously collected during a mass production process. The prediction model may use a machine learning and deep learning AI algorithm.

In Step S6, based on the film formation quality prediction model, the film formation quality of the lithium-ion battery in the formation process is predicted every several seconds, and the deviation between the film formation quality and the expected film formation quality is detected, and a closed-loop fine adjustment of at least part of the formation process parameters is performed in the parameter adjustment order according to the deviation, until the formation process is completed.

It should be noted that the steps shown in the flow chart of the accompanying drawings can be executed in a computer system such as a set of computer executable instructions, and that, although a logical order is shown in the flow chart, in some cases, the steps shown or described can be executed in another order different from that shown herein.

An embodiment of the present application further provides a control device for lithium-ion battery formation. It should be noted that the control device for lithium-ion battery formation of the embodiment of the present application can be used for executing the control methods for lithium-ion battery formation provided by the embodiments the present application. The device is used to realize the embodiments and optional embodiments above, and the description has been made will not be repeatedly illustrated. As described hereinafter, the term "module" can be a combination of software and/or hardware that can realize predetermined functions. Although the devices described in the following embodiments are preferably realized with software, the realization thereof by hardware or by a combination of software and hardware is also possible and conceived.

The embodiments of the control device for lithium-ion battery formation provided by the present application are described hereinafter.

FIG. 2 is a block diagram showing a control device for lithium-ion battery formation according to an embodiment of the present application, as shown in FIG. 2, the device includes a first determination unit 10, an acquisition unit 20, a second determination unit 30, and an adjustment unit 40.

The first determination unit 10 is configured to determine film formation quality of a target lithium-ion battery. The target lithium-ion battery is a lithium-ion battery in a formation process.

Specifically, the film formation quality refers to actual quality of the formed SEI film.

The acquisition unit 20 is configured to obtained a plurality of formation data sets of the lithium-ion battery. Each formation data set includes a plurality of data groups, which are in a one-to-one correspondence with a plurality of formation time points during a formation process, and each data group includes historical film formation quality, an SEI film impedance and an interface charge transfer impedance of a corresponding formation time point.

Specifically, in each formation data set, each data group corresponding to a formation time point includes the historical film formation quality, the SEI film impedance and the interface charge transfer impedance. Different formation data sets include data groups correspond to the same formation time point. For example, the plurality of formation data sets each include data groups corresponding to the first formation time point, the second formation time point, etc., and the n-th formation time point, respectively. Therefore, the plurality of formation data sets each include a data group including the historical film formation quality, the SEI film impedance and the interface charge transfer impedance corresponding to each formation time point.

The second determination unit 30 is configured to determine an optimal film formation quality corresponding to each formation time point from the plurality of the formation data sets according to constraint conditions, and obtain an expected film formation quality corresponding to each formation time point. The constraint conditions include: for each formation time point, the SEI film impedance corresponding to the historical film formation quality being less than a first threshold, and the interface charge transfer impedance corresponding to the historical film formation quality being less than a second threshold.

Specifically, among the plurality of data groups corresponding to a formation time point, the historical film formation quality in a data group, in which the SEI film impedance is less than the first threshold and the interface charge transfer impedance is less than the second threshold, is the optimal film formation quality at this formation time point.

The adjustment unit 40 is configured to adjust target parameters in a parameter adjustment order determined according to the deviation, when a deviation between the film formation quality and the expected film formation quality does not satisfy a predetermined requirement, so that after the target parameters are adjusted, the deviation corresponding to the formation process meets the predetermined requirement. The target parameters are the to-be- adjusted formation process parameters determined according to the deviation, and the parameter adjustment order is an adjustment order of the target parameters, and formation process parameters are process parameters that affect the film formation quality in the formation process.

Specifically, when magnitudes of the deviations are different, and the corresponding to-be-adjusted formation process parameters are also different.

In the embodiments above, the film formation quality of the target lithium-ion battery in the formation process is first determined by the first determination unit. Then, the plurality of formation data sets of the lithium-ion battery are obtained by the acquisition unit, and each formation data set includes the plurality of data groups, which are in a one-to-one correspondence with the plurality of formation time points during a formation process, and each data group includes the historical film formation quality, the SEI film impedance and the interface charge transfer impedance of a corresponding formation time point. Then, according to the constraint conditions, the optimal film formation quality corresponding to each formation time point is determined by the second determination unit from the plurality of the formation data sets, to obtain the expected film formation quality corresponding to each formation time point. The constraint conditions include: for each formation time point, the SEI film impedance corresponding to the historical film formation quality being less than the first threshold, and the interface charge transfer impedance corresponding to the historical film formation quality being less than the second threshold. Finally, when the deviation between the film formation quality of the target lithium-ion battery and the expected film formation quality does not satisfy the predetermined requirement, the adjustment unit adjusts the target parameters that affect the film formation quality in parameter adjustment order, so that after the adjustment, the deviation meets the predetermined requirement. In the present application, the expected film formation quality at each formation time point during the formation process are determined from the plurality of formation data sets, and the target parameters affecting the film formation quality are adjusted in the parameter adjustment order according to the deviation between the actual film formation quality of the lithium-ion battery in the formation process and the expected film formation quality, so that after the adjustment, the deviation satisfies the predetermined requirement, that is, the adjusted SEI film formation quality approximates to the expected film formation quality, thereby realizing an online regulation of the SEI film formation quality during the formation process of the lithium-ion battery, ensuring the great consistency of the SEI film formation quality of different battery cells, solving the problem of the great difference in the SEI film formation during the formation process of the prior art, and ensuring the great consistency of the electrical performance of the battery cells.

The control device for lithium-ion battery formation includes a processor and a memory. The first determination unit, the acquisition unit, the second determination unit, and the adjustment unit are all stored in the memory as program units, and the processor executes the program units stored in the memory to realize corresponding functions. The units are all located in the same processor. Alternatively, the units, in forms of any combination thereof, are located in different processors.

An embodiment of the present invention provides a computer-readable storage medium. The computer-readable storage medium includes a program stored thereon. The program, when executed by a processor, executes the control method for lithium-ion battery formation.

Specifically, the control method for lithium-ion battery formation includes the following steps S201 to S204.

In Step S201, film formation quality of a target lithium-ion battery is determined. The target lithium-ion battery is a lithium-ion battery in a formation process.

Specifically, the film formation quality refers to actual quality of the formed SEI film.

In Step S202, a plurality of formation data sets of the lithium-ion battery are obtained. Each formation data set includes a plurality of data groups, which are in a one-to-one correspondence with a plurality of formation time points during a formation process, and each data group includes historical film formation quality, an SEI film impedance and an interface charge transfer impedance of a corresponding formation time point.

Specifically, in each formation data set, each data group corresponding to a formation time point includes the historical film formation quality, the SEI film impedance and the interface charge transfer impedance. Different formation data sets include data groups correspond to the same formation time point. For example, the plurality of formation data sets each include data groups corresponding to the first formation time point, the second formation time point, etc., and the n-th formation time point, respectively. Therefore, the plurality of formation data sets each include a data group including the historical film formation quality, the SEI film impedance and the interface charge transfer impedance corresponding to each formation time point.

In Step S203, according to constraint conditions, an optimal film formation quality corresponding to each formation time point is determined from the plurality of the formation data sets, and an expected film formation quality corresponding to each formation time point is obtained. The constraint conditions include: for each formation time point, the SEI film impedance corresponding to the historical film formation quality being less than a first threshold, and the interface charge transfer impedance corresponding to the historical film formation quality being less than a second threshold.

Specifically, among the plurality of data groups corresponding to a formation time point, the historical film formation quality in a data group, in which the SEI film impedance is less than the first threshold and the interface charge transfer impedance is less than the second threshold, is the optimal film formation quality at this formation time point.

In Step S204, when a deviation between the film formation quality and the expected film formation quality does not satisfy a predetermined requirement, target parameters are adjusted in a parameter adjustment order determined according to the deviation, so that after the target parameters are adjusted, the deviation corresponding to the formation process meets the predetermined requirement. The target parameters are the to-be- adjusted formation process parameters determined according to the deviation, and the parameter adjustment order is an adjustment order of the target parameters, and formation process parameters are process parameters that affect the film formation quality in the formation process.

Specifically, when magnitudes of the deviations are different, and the corresponding to-be-adjusted formation process parameters are also different.

Optionally, the formation working conditions corresponding to any two of the formation data sets are different, and each data group in a formation data set also includes formation gas production data at a formation time point during a formation process corresponding to the data group, and the constraint conditions further include: a change rate of the formation gas production data corresponding to the historical film formation quality at each formation time point being less than a third threshold.

Optionally, determining the optimal film formation quality corresponding to each formation time point from the plurality of the formation data sets according to the constraint conditions in step S203 includes: establishing a planning model, where a variable of the planning model is a historical film formation quality, and a target of the planning model is that a weighted sum of a change rate of the formation gas production data, SEI film impedance and an interface charge transfer impedance at the same formation time point is the minimum; inputting the plurality of formation data sets into the planning model, and determining the optimal solution of the formation quality corresponding to each formation time point according to the constraint conditions, to obtain the optimal film formation qualities corresponding to the plurality of formation time points respectively.

Optionally, after obtaining the expected film formation quality corresponding to each formation time point in step S203, and before adjusting the target parameters in the parameter adjustment order determined according to the deviation in step 204, the method further includes: determining a formation time point corresponding to the film formation quality as a target time point, and determining the expected film formation quality corresponding to the target time point as a target expected quality, and the target expected quality being the expected film formation quality corresponding to the film formation quality; calculating a difference between the film formation quality and the target expected quality to obtain the deviation.

Optionally, before Step S201 of determining the film formation quality of the target lithium-ion battery, the method further includes determining that the formation process parameters include a formation current, a remaining power, and a formation temperature based on a film formation reaction equation of the formation process. The step S204 of adjusting the target parameters in the parameter adjustment order determined according to the deviation when the deviation between the film formation quality and the expected film formation quality does not satisfy the predetermined requirement includes: when the deviation is greater than a fourth threshold and less than or equal to a fifth threshold, determining that the target parameters include the formation current and the remaining power, and determining that the parameter adjustment order is to adjust the formation current and the remaining power in sequence; when the deviation is greater than the fifth threshold and less than or equal to the sixth threshold, determining that the target parameters include the formation temperature and the formation current, and determining that the parameter adjustment order is to adjust the formation current and the formation temperature in sequence; when the deviation is greater than the sixth threshold, determining that the target parameters include the formation temperature, the remaining power and the formation current, and determining that the parameter adjustment order is to adjust the formation current, the remaining power and the formation temperature in sequence.

Optionally, the first threshold is in a range of 0.5*Ω* ± 5%, the second threshold is in a range of 2*Ω* ± 5%, and the third threshold is in a range of 16 *mL*/*V* ± 5%.

In addition to the ranges described above, those skilled in the art can flexibly set the ranges of the first, second, and third thresholds according to design requirements.

Optionally, determining the film formation quality of the target lithium-ion battery includes: obtaining actual parameter values of the formation process parameters of the target lithium-ion battery; establishing a film formation quality prediction model, which characterizes a corresponding relationship between the formation process parameters and the film formation quality; and determining the film formation quality corresponding to the actual parameter values based on the film formation quality prediction model and the actual parameter values.

Optionally, establishing the film formation quality prediction model includes: obtaining a training data set, the training data set including a plurality of training data groups, each training data group including historical parameter values of the formation process parameters, and historical film formation quality of the lithium-ion battery obtained through information using the historical parameter values; establishing an initial prediction model; adjusting model parameters of the initial prediction model according to the training data set to obtain the film formation quality prediction model.

Optionally, before determining the film formation quality of the target lithium-ion battery, the method further includes: according to a pseudo two-dimensional (P2D) theoretical model of the target lithium-ion battery, determining that the evaluation parameters of the film formation quality include at least one of: a battery DC internal resistance, a battery capacity, a peak value of battery voltage differential capacity, an integral value of the battery voltage differential capacity over voltage. That is, the film formation quality is characterized by at least one of the battery DC internal resistance, the battery capacity, the peak value of the battery voltage differential capacity, and the integral value of the battery voltage differential capacity over voltage.

An embodiment of the present invention provides a computer device, including a processor and a memory, the memory has a computer program stored thereon. The processor, when executing the computer program, implements the control method for lithium-ion battery formation.

Specifically, the control method for lithium-ion battery formation includes the following steps S201 to S204.

In Step S201, film formation quality of a target lithium-ion battery is determined. The target lithium-ion battery is a lithium-ion battery in a formation process.

Specifically, the film formation quality refers to actual quality of the formed SEI film.

In Step S202, a plurality of formation data sets of the lithium-ion battery are obtained. Each formation data set includes a plurality of data groups, which are in a one-to-one correspondence with a plurality of formation time points during a formation process, and each data group includes historical film formation quality, an SEI film impedance and an interface charge transfer impedance of a corresponding formation time point.

Specifically, in each formation data set, each data group corresponding to a formation time point includes the historical film formation quality, the SEI film impedance and the interface charge transfer impedance. Different formation data sets include data groups correspond to the same formation time point. For example, the plurality of formation data sets each include data groups corresponding to the first formation time point, the second formation time point, etc., and the n-th formation time point, respectively. Therefore, the plurality of formation data sets each include a data group including the historical film formation quality, the SEI film impedance and the interface charge transfer impedance corresponding to each formation time point.

In Step S203, according to constraint conditions, an optimal film formation quality corresponding to each formation time point is determined from the plurality of the formation data sets, and an expected film formation quality corresponding to each formation time point is obtained. The constraint conditions include: for each formation time point, the SEI film impedance corresponding to the historical film formation quality being less than a first threshold, and the interface charge transfer impedance corresponding to the historical film formation quality being less than a second threshold.

Specifically, among the plurality of data groups corresponding to a formation time point, the historical film formation quality in a data group, in which the SEI film impedance is less than the first threshold and the interface charge transfer impedance is less than the second threshold, is the optimal film formation quality at this formation time point.

In Step S204, when a deviation between the film formation quality and the expected film formation quality does not satisfy a predetermined requirement, target parameters are adjusted in a parameter adjustment order determined according to the deviation, so that after the target parameters are adjusted, the deviation corresponding to the formation process meets the predetermined requirement. The target parameters are the to-be- adjusted formation process parameters determined according to the deviation, and the parameter adjustment order is an adjustment order of the target parameters, and formation process parameters are process parameters that affect the film formation quality in the formation process.

Specifically, when magnitudes of the deviations are different, and the corresponding to-be-adjusted formation process parameters are also different.

Optionally, the formation working conditions corresponding to any two of the formation data sets are different, and each data group in a formation data set also includes formation gas production data at a formation time point during a formation process corresponding to the data group, and the constraint conditions further include: a change rate of the formation gas production data corresponding to the historical film formation quality at each formation time point being less than a third threshold.

Optionally, determining the optimal film formation quality corresponding to each formation time point from the plurality of the formation data sets according to the constraint conditions in step S203 includes: establishing a planning model, where a variable of the planning model is a historical film formation quality, and a target of the planning model is that a weighted sum of a change rate of the formation gas production data, SEI film impedance and an interface charge transfer impedance at the same formation time point is the minimum; inputting the plurality of formation data sets into the planning model, and determining the optimal solution of the formation quality corresponding to each formation time point according to the constraint conditions, to obtain the optimal film formation qualities corresponding to the plurality of formation time points respectively.

Optionally, after obtaining the expected film formation quality corresponding to each formation time point in step S203, and before adjusting the target parameters in the parameter adjustment order determined according to the deviation in step 204, the method further includes: determining a formation time point corresponding to the film formation quality as a target time point, and determining the expected film formation quality corresponding to the target time point as a target expected quality, and the target expected quality being the expected film formation quality corresponding to the film formation quality; calculating a difference between the film formation quality and the target expected quality to obtain the deviation.

Optionally, before Step S201 of determining the film formation quality of the target lithium-ion battery, the method further includes determining that the formation process parameters include a formation current, a remaining power, and a formation temperature based on a film formation reaction equation of the formation process. The step S204 of adjusting the target parameters in the parameter adjustment order determined according to the deviation when the deviation between the film formation quality and the expected film formation quality does not satisfy the predetermined requirement includes: when the deviation is greater than a fourth threshold and less than or equal to a fifth threshold, determining that the target parameters include the formation current and the remaining power, and determining that the parameter adjustment order is to adjust the formation current and the remaining power in sequence; when the deviation is greater than the fifth threshold and less than or equal to the sixth threshold, determining that the target parameters include the formation temperature and the formation current, and determining that the parameter adjustment order is to adjust the formation current and the formation temperature in sequence; when the deviation is greater than the sixth threshold, determining that the target parameters include the formation temperature, the remaining power and the formation current, and determining that the parameter adjustment order is to adjust the formation current, the remaining power and the formation temperature in sequence.

Optionally, the first threshold is in a range of 0.5*Ω* ± 5%, the second threshold is in a range of 2*Ω* ± 5%, and the third threshold is in a range of 16 *mL*/*V* ± 5%.

In addition to the ranges described above, those skilled in the art can flexibly set the ranges of the first, second, and third thresholds according to design requirements.

Optionally, determining the film formation quality of the target lithium-ion battery includes: obtaining actual parameter values of the formation process parameters of the target lithium-ion battery; establishing a film formation quality prediction model, which characterizes a corresponding relationship between the formation process parameters and the film formation quality; and determining the film formation quality corresponding to the actual parameter values based on the film formation quality prediction model and the actual parameter values.

Optionally, establishing the film formation quality prediction model includes: obtaining a training data set, the training data set including a plurality of training data groups, each training data group including historical parameter values of the formation process parameters, and historical film formation quality of the lithium-ion battery obtained through information using the historical parameter values; establishing an initial prediction model; adjusting model parameters of the initial prediction model according to the training data set to obtain the film formation quality prediction model.

Optionally, before determining the film formation quality of the target lithium-ion battery, the method further includes: according to a pseudo two-dimensional (P2D) theoretical model of the target lithium-ion battery, determining that the evaluation parameters of the film formation quality include at least one of: a battery DC internal resistance, a battery capacity, a peak value of battery voltage differential capacity, an integral value of the battery voltage differential capacity over voltage. That is, the film formation quality is characterized by at least one of the battery DC internal resistance, the battery capacity, the peak value of the battery voltage differential capacity, and the integral value of the battery voltage differential capacity over voltage.

An embodiment of the present invention provides a lithium-ion battery formation system, including: a lithium-ion battery formation device and a control device for the lithium-ion battery formation device.

The lithium-ion battery formation device is configured to perform a lithium-ion battery formation process.

The control device for the lithium-ion battery formation device includes one or more processors, a memory and one or more programs. The one or more programs are stored in the memory and configured to be executed by the one or more processors. The one or more processors, when executing the one or more programs, implement at least the following steps S201 to S204.

In Step S201, film formation quality of a target lithium-ion battery is determined. The target lithium-ion battery is a lithium-ion battery in a formation process.

Specifically, the film formation quality refers to actual quality of the formed SEI film.

In Step S202, a plurality of formation data sets of the lithium-ion battery are obtained. Each formation data set includes a plurality of data groups, which are in a one-to-one correspondence with a plurality of formation time points during a formation process, and each data group includes historical film formation quality, an SEI film impedance and an interface charge transfer impedance of a corresponding formation time point.

Specifically, in each formation data set, each data group corresponding to a formation time point includes the historical film formation quality, the SEI film impedance and the interface charge transfer impedance. Different formation data sets include data groups correspond to the same formation time point. For example, the plurality of formation data sets each include data groups corresponding to the first formation time point, the second formation time point, etc., and the n-th formation time point, respectively. Therefore, the plurality of formation data sets each include a data group including the historical film formation quality, the SEI film impedance and the interface charge transfer impedance corresponding to each formation time point.

In Step S203, according to constraint conditions, an optimal film formation quality corresponding to each formation time point is determined from the plurality of the formation data sets, and an expected film formation quality corresponding to each formation time point is obtained. The constraint conditions include: for each formation time point, the SEI film impedance corresponding to the historical film formation quality being less than a first threshold, and the interface charge transfer impedance corresponding to the historical film formation quality being less than a second threshold.

Specifically, among the plurality of data groups corresponding to a formation time point, the historical film formation quality in a data group, in which the SEI film impedance is less than the first threshold and the interface charge transfer impedance is less than the second threshold, is the optimal film formation quality at this formation time point.

In Step S204, when a deviation between the film formation quality and the expected film formation quality does not satisfy a predetermined requirement, target parameters are adjusted in a parameter adjustment order determined according to the deviation, so that after the target parameters are adjusted, the deviation corresponding to the formation process meets the predetermined requirement. The target parameters are the to-be- adjusted formation process parameters determined according to the deviation, and the parameter adjustment order is an adjustment order of the target parameters, and formation process parameters are process parameters that affect the film formation quality in the formation process.

Specifically, when magnitudes of the deviations are different, and the corresponding to-be-adjusted formation process parameters are also different.

In the embodiments of the lithium-ion battery formation system, the lithium-ion battery formation device performs the formation process, and the control device for the lithium-ion battery formation device performs the control method for the lithium-ion battery formation. In the method, the expected film formation quality at each formation time point during the formation process are determined from the plurality of formation data sets, and the target parameters affecting the film formation quality are adjusted in the parameter adjustment order according to the deviation between the actual film formation quality of the lithium-ion battery in the formation process and the expected film formation quality, so that after the adjustment, the deviation satisfies the predetermined requirement, that is, the adjusted SEI film formation quality approximates to the expected film formation quality, thereby realizing an online regulation of the SEI film formation quality during the formation process of the lithium-ion battery, ensuring the great consistency of the SEI film formation quality of different battery cells, solving the problem of the great difference in the SEI film formation during the formation process of the prior art, and ensuring the great consistency of the electrical performance of the battery cells manufactured by the lithium-ion battery formation system.

In the present application, the control device for the lithium-ion battery formation device can be a server, a personal computer, a PAD, and a mobile phone, etc.

Optionally, the formation working conditions corresponding to any two of the formation data sets are different, and each data group in a formation data set also includes formation gas production data at a formation time point during a formation process corresponding to the data group, and the constraint conditions further include: a change rate of the formation gas production data corresponding to the historical film formation quality at each formation time point being less than a third threshold.

Optionally, determining the optimal film formation quality corresponding to each formation time point from the plurality of the formation data sets according to the constraint conditions in step S203 includes: establishing a planning model, where a variable of the planning model is a historical film formation quality, and a target of the planning model is that a weighted sum of a change rate of the formation gas production data, SEI film impedance and an interface charge transfer impedance at the same formation time point is the minimum; inputting the plurality of formation data sets into the planning model, and determining the optimal solution of the formation quality corresponding to each formation time point according to the constraint conditions, to obtain the optimal film formation qualities corresponding to the plurality of formation time points respectively.

Optionally, after obtaining the expected film formation quality corresponding to each formation time point in step S203, and before adjusting the target parameters in the parameter adjustment order determined according to the deviation in step 204, the method further includes: determining a formation time point corresponding to the film formation quality as a target time point, and determining the expected film formation quality corresponding to the target time point as a target expected quality, and the target expected quality being the expected film formation quality corresponding to the film formation quality; calculating a difference between the film formation quality and the target expected quality to obtain the deviation.

Optionally, before Step S201 of determining the film formation quality of the target lithium-ion battery, the method further includes determining that the formation process parameters include a formation current, a remaining power, and a formation temperature based on a film formation reaction equation of the formation process. The step S204 of adjusting the target parameters in the parameter adjustment order determined according to the deviation when the deviation between the film formation quality and the expected film formation quality does not satisfy the predetermined requirement includes: when the deviation is greater than a fourth threshold and less than or equal to a fifth threshold, determining that the target parameters include the formation current and the remaining power, and determining that the parameter adjustment order is to adjust the formation current and the remaining power in sequence; when the deviation is greater than the fifth threshold and less than or equal to the sixth threshold, determining that the target parameters include the formation temperature and the formation current, and determining that the parameter adjustment order is to adjust the formation current and the formation temperature in sequence; when the deviation is greater than the sixth threshold, determining that the target parameters include the formation temperature, the remaining power and the formation current, and determining that the parameter adjustment order is to adjust the formation current, the remaining power and the formation temperature in sequence.

Optionally, the first threshold is in a range of 0.5*Ω* ± 5%, the second threshold is in a range of 2*Ω* ± 5%, and the third threshold is in a range of 16 *mL*/*V* ± 5%.

In addition to the ranges described above, those skilled in the art can flexibly set the ranges of the first, second, and third thresholds according to design requirements.

Optionally, determining the film formation quality of the target lithium-ion battery includes: obtaining actual parameter values of the formation process parameters of the target lithium-ion battery; establishing a film formation quality prediction model, which characterizes a corresponding relationship between the formation process parameters and the film formation quality; and determining the film formation quality corresponding to the actual parameter values based on the film formation quality prediction model and the actual parameter values.

Optionally, establishing the film formation quality prediction model includes: obtaining a training data set, the training data set including a plurality of training data groups, each training data group including historical parameter values of the formation process parameters, and historical film formation quality of the lithium-ion battery obtained through information using the historical parameter values; establishing an initial prediction model; adjusting model parameters of the initial prediction model according to the training data set to obtain the film formation quality prediction model.

Optionally, before determining the film formation quality of the target lithium-ion battery, the method further includes: according to a pseudo two-dimensional (P2D) theoretical model of the target lithium-ion battery, determining that the evaluation parameters of the film formation quality include at least one of: a battery DC internal resistance, a battery capacity, a peak value of battery voltage differential capacity, an integral value of the battery voltage differential capacity over voltage. That is, the film formation quality is characterized by at least one of the battery DC internal resistance, the battery capacity, the peak value of the battery voltage differential capacity, and the integral value of the battery voltage differential capacity over voltage.

The present application also provides a computer program product, including computer instructions. The computer instructions, when executed by a processor, implement at least the following steps S201 to S204 of the method.

In Step S201, film formation quality of a target lithium-ion battery is determined. The target lithium-ion battery is a lithium-ion battery in a formation process.

In Step S202, a plurality of formation data sets of the lithium-ion battery are obtained. Each formation data set includes a plurality of data groups, which are in a one-to-one correspondence with a plurality of formation time points during a formation process, and each data group includes historical film formation quality, an SEI film impedance and an interface charge transfer impedance of a corresponding formation time point.

In Step S203, according to constraint conditions, an optimal film formation quality corresponding to each formation time point is determined from the plurality of the formation data sets, and an expected film formation quality corresponding to each formation time point is obtained. The constraint conditions include: for each formation time point, the SEI film impedance corresponding to the historical film formation quality being less than a first threshold, and the interface charge transfer impedance corresponding to the historical film formation quality being less than a second threshold.

In Step S204, when a deviation between the film formation quality and the expected film formation quality does not satisfy a predetermined requirement, target parameters are adjusted in a parameter adjustment order determined according to the deviation, so that after the target parameters are adjusted, the deviation corresponding to the formation process meets the predetermined requirement. The target parameters are the to-be- adjusted formation process parameters determined according to the deviation, and the parameter adjustment order is an adjustment order of the target parameters, and formation process parameters are process parameters that affect the film formation quality in the formation process.

Optionally, the formation working conditions corresponding to any two of the formation data sets are different, and each data group in a formation data set also includes formation gas production data at a formation time point during a formation process corresponding to the data group, and the constraint conditions further include: a change rate of the formation gas production data corresponding to the historical film formation quality at each formation time point being less than a third threshold.

Optionally, determining the optimal film formation quality corresponding to each formation time point from the plurality of the formation data sets according to the constraint conditions in step S203 includes: establishing a planning model, where a variable of the planning model is a historical film formation quality, and a target of the planning model is that a weighted sum of a change rate of the formation gas production data, SEI film impedance and an interface charge transfer impedance at the same formation time point is the minimum; inputting the plurality of formation data sets into the planning model, and determining the optimal solution of the formation quality corresponding to each formation time point according to the constraint conditions, to obtain the optimal film formation qualities corresponding to the plurality of formation time points respectively.

Optionally, after obtaining the expected film formation quality corresponding to each formation time point in step S203, and before adjusting the target parameters in the parameter adjustment order determined according to the deviation in step 204, the method further includes: determining a formation time point corresponding to the film formation quality as a target time point, and determining the expected film formation quality corresponding to the target time point as a target expected quality, and the target expected quality being the expected film formation quality corresponding to the film formation quality; calculating a difference between the film formation quality and the target expected quality to obtain the deviation.

Optionally, before Step S201 of determining the film formation quality of the target lithium-ion battery, the method further includes determining that the formation process parameters include a formation current, a remaining power, and a formation temperature based on a film formation reaction equation of the formation process. The step S204 of adjusting the target parameters in the parameter adjustment order determined according to the deviation when the deviation between the film formation quality and the expected film formation quality does not satisfy the predetermined requirement includes: when the deviation is greater than a fourth threshold and less than or equal to a fifth threshold, determining that the target parameters include the formation current and the remaining power, and determining that the parameter adjustment order is to adjust the formation current and the remaining power in sequence; when the deviation is greater than the fifth threshold and less than or equal to the sixth threshold, determining that the target parameters include the formation temperature and the formation current, and determining that the parameter adjustment order is to adjust the formation current and the formation temperature in sequence; when the deviation is greater than the sixth threshold, determining that the target parameters include the formation temperature, the remaining power and the formation current, and determining that the parameter adjustment order is to adjust the formation current, the remaining power and the formation temperature in sequence.

Optionally, the first threshold is in a range of 0.5*Ω* ± 5%, the second threshold is in a range of 2*Ω* ± 5%, and the third threshold is in a range of 16 *mL*/*V* ± 5%.

In addition to the ranges described above, those skilled in the art can flexibly set the ranges of the first, second, and third thresholds according to design requirements.

Optionally, determining the film formation quality of the target lithium-ion battery includes: obtaining actual parameter values of the formation process parameters of the target lithium-ion battery; establishing a film formation quality prediction model, which characterizes a corresponding relationship between the formation process parameters and the film formation quality; and determining the film formation quality corresponding to the actual parameter values based on the film formation quality prediction model and the actual parameter values.

Optionally, establishing the film formation quality prediction model includes: obtaining a training data set, the training data set including a plurality of training data groups, each training data group including historical parameter values of the formation process parameters, and historical film formation quality of the lithium-ion battery obtained through information using the historical parameter values; establishing an initial prediction model; adjusting model parameters of the initial prediction model according to the training data set to obtain the film formation quality prediction model.

Optionally, before determining the film formation quality of the target lithium-ion battery, the method further includes: according to a pseudo two-dimensional (P2D) theoretical model of the target lithium-ion battery, determining that the evaluation parameters of the film formation quality include at least one of: a battery DC internal resistance, a battery capacity, a peak value of battery voltage differential capacity, an integral value of the battery voltage differential capacity over voltage. That is, the film formation quality is characterized by at least one of the battery DC internal resistance, the battery capacity, the peak value of the battery voltage differential capacity, and the integral value of the battery voltage differential capacity over voltage.

From the above description, it can be seen that the embodiments described in this application achieve the following technical effects.

In the control method for lithium-ion battery formation of the present application, the film formation quality of the target lithium-ion battery in the formation process is first determined. Then, the plurality of formation data sets of the lithium-ion battery are obtained, and each formation data set includes the plurality of data groups, which are in a one-to-one correspondence with the plurality of formation time points during a formation process, and each data group includes the historical film formation quality, the SEI film impedance and the interface charge transfer impedance of a corresponding formation time point. Then, according to the constraint conditions, the optimal film formation quality corresponding to each formation time point is determined from the plurality of the formation data sets, and the expected film formation quality corresponding to each formation time point is obtained. The constraint conditions include: for each formation time point, the SEI film impedance corresponding to the historical film formation quality being less than the first threshold, and the interface charge transfer impedance corresponding to the historical film formation quality being less than the second threshold. Finally, when the deviation between the film formation quality of the target lithium-ion battery and the expected film formation quality does not satisfy the predetermined requirement, the target parameters that affect the film formation quality are adjusted in parameter adjustment order, so that after the adjustment, the deviation meets the predetermined requirement. In the present application, the expected film formation quality at each formation time point during the formation process are determined from the plurality of formation data sets, and the target parameters affecting the film formation quality are adjusted in the parameter adjustment order according to the deviation between the actual film formation quality of the lithium-ion battery in the formation process and the expected film formation quality, so that after the adjustment, the deviation satisfies the predetermined requirement, that is, the adjusted SEI film formation quality approximates to the expected film formation quality, thereby realizing an online regulation of the SEI film formation quality during the formation process of the lithium-ion battery, ensuring the great consistency of the SEI film formation quality of different battery cells, solving the problem of the great difference in the SEI film formation during the formation process of the prior art, and ensuring the great consistency of the electrical performance of the battery cells.

## Claims

1. A control method for lithium-ion battery formation, **characterized by** comprising:
determining film formation quality of a target lithium-ion battery, wherein the target lithium-ion battery is a lithium-ion battery in a formation process;
obtaining a plurality of formation data sets of the lithium-ion battery, wherein each formation data set comprises a plurality of data groups in a one-to-one correspondence with a plurality of formation time points during the formation process, and each data group comprises historical film formation quality, a solid electrolyte interface (SEI) film impedance and an interface charge transfer impedance of a corresponding formation time point;
determining an optimal film formation quality corresponding to each formation time point from the plurality of the formation data sets according to constraint conditions, and obtaining an expected film formation quality corresponding to each formation time point; wherein the constraint conditions comprise: for each formation time point, the SEI film impedance corresponding to the historical film formation quality being less than a first threshold, and the interface charge transfer impedance corresponding to the historical film formation quality being less than a second threshold; and
adjusting target parameters in a parameter adjustment order determined according to a deviation when the deviation between the film formation quality and the expected film formation quality does not satisfy a predetermined requirement, so that after the target parameters are adjusted, the deviation corresponding to the formation process meets the predetermined requirement; wherein the target parameters are to-be-adjusted formation process parameters determined according to the deviation, the parameter adjustment order is an adjustment order of the target parameters, and formation process parameters are process parameters affecting the film formation quality in the formation process;
wherein formation working conditions corresponding to any two of the formation data sets are different, and each data group in each formation data set further comprises formation gas production data at a formation time point during a formation process corresponding to each data group; and the constraint conditions further comprise: a change rate of the formation gas production data corresponding to the historical film formation quality at each formation time point being less than a third threshold;
wherein determining the optimal film formation quality corresponding to each formation time point from the plurality of the formation data sets according to the constraint conditions comprises:
establishing a planning model, wherein a variable of the planning model is the historical film formation quality, and a target of the planning model is that a weighted sum of the change rate of the formation gas production data, the SEI film impedance and the interface charge transfer impedance at a same formation time point is the minimum; and
inputting the plurality of formation data sets into the planning model, and determining the optimal formation quality corresponding to each formation time point according to the constraint conditions to obtain optimal film formation qualities corresponding to the plurality of formation time points respectively;
wherein before determining the film formation quality of the target lithium-ion battery, the method further comprises determining that the formation process parameters comprise a formation current, a remaining power, and a formation temperature based on a film formation reaction equation of the formation process;
wherein adjusting the target parameters in the parameter adjustment order determined according to the deviation when the deviation between the film formation quality and the expected film formation quality does not satisfy the predetermined requirement comprises:
when the deviation is greater than a fourth threshold and less than or equal to a fifth threshold, determining that the target parameters comprise the formation current and the remaining power, and determining that the parameter adjustment order is to adjust the formation current and the remaining power in sequence;
when the deviation is greater than the fifth threshold and less than or equal to the sixth threshold, determining that the target parameters comprise the formation temperature and the formation current, and determining that the parameter adjustment order is to adjust the formation current and the formation temperature in sequence; and
when the deviation is greater than the sixth threshold, determining that the target parameters comprise the formation temperature, the remaining power and the formation current, and determining that the parameter adjustment order is to adjust the formation current, the remaining power and the formation temperature in sequence;
wherein the predetermined requirement is that the deviation between the film formation quality and the expected film formation quality is less than or equal to the fourth threshold; the fourth threshold is less than the fifth threshold, and the fifth threshold is less than the sixth threshold; and
wherein determining the film formation quality of the target lithium-ion battery comprises:
obtaining actual parameter values of the formation process parameters of the target lithium-ion battery;
establishing a film formation quality prediction model that characterizes a corresponding relationship between the formation process parameters and the film formation quality; and
determining the film formation quality corresponding to the actual parameter values based on the film formation quality prediction model and the actual parameter values.

2. The method according to claim 1, wherein after obtaining the expected film formation quality corresponding to each formation time point, and before adjusting the target parameters in the parameter adjustment order determined according to the deviation, the method further comprises:
determining a formation time point corresponding to the film formation quality as a target time point, and determining an expected film formation quality corresponding to the target time point as a target expected quality, wherein the target expected quality is the expected film formation quality corresponding to the film formation quality; and
calculating a difference between the film formation quality and the target expected quality to obtain the deviation.

3. The method according to claim 1 or 2, wherein the first threshold is in a range of 0.5*Ω* ± 5%, the second threshold is in a range of 2Ω ± 5%, and the third threshold is in a range of 16 *mL*/*V* ± 5%.

4. The method according to any one of claims 1 to 3, wherein establishing the film formation quality prediction model comprises:
obtaining a training data set, wherein the training data set comprises a plurality of training data groups, each training data group comprises historical parameter values of the formation process parameters, and the historical film formation quality of the lithium-ion battery obtained through information using the historical parameter values;
establishing an initial prediction model; and
adjusting model parameters of the initial prediction model according to the training data set to obtain the film formation quality prediction model.

5. The method according to any one of claims 1 to 4, wherein the prediction model comprises one or a coupling of more of a machine learning model, a deep learning model, and a semi-empirical model.

6. The method according to any one of claims 1 to 5, wherein a weight value of the change rate of the formation gas production data, a weight value of the SEI film impedance, and a weight value of the interface charge transfer impedance are the same.

7. The method according to any one of claims 1 to 6, wherein the formation working conditions comprise charging rates.

8. The method according to any one of claims 1 to 6, wherein the formation working conditions comprise formation negative pressures.

9. The method according to claim 8, wherein the formation negative pressures comprise -60 kPa, -70 kPa, and -80 kPa.

10. The method according to any one of claims 1 to 6, wherein the formation working conditions comprise states of charge.

11. The method according to claim 10, wherein the states of charge comprise 6%, 15%, and 30%.

12. A lithium-ion battery formation system, **characterized by** comprising:
a lithium-ion battery formation device, configured to perform a lithium-ion battery formation process; and
a control device for the lithium-ion battery formation device, wherein: the control device comprises one or more processors, a memory, and one or more programs; the one or more programs are stored in the memory and configured to be executed by the one or more processors; and the one or more processors, when executing the one or more programs, implement the method according to any one of claims 1 to 11.

13. A computer-readable storage medium, having a program stored thereon, wherein the program, when executed by a processor, executes the control method according to any one of claims 1 to 11.

14. A computer device, comprising a processor and a memory, wherein the memory has a computer program stored thereon, and the processor, when executing the computer program, implements the control method according to any one of claims 1 to 11.

15. A computer program product, comprising computer instructions, wherein the computer instructions, when executed by a processor, execute the control method according to any one of claims 1 to 11.
